# EUROPEAN PATENT APPLICATION

(11) **EP 0 874 394 A2**
(43) Date of publication of application: **28.10.1998**
(21) Application number: 98107170.7
(22) Date of filing: 20.04.1998
(51) Int. Cl.: H01L 21/337, H01L 29/808

(54) **GaAs vertical fet**

(30) Priority: 23.04.1997 US 839118
(71) Applicant: MOTOROLA, INC., Schaumburg, IL 60196 (US)
(72) Inventor: Thero, Christine, No. 184 Scottsdale, Arizona 85251 (US); Weitzel, Charles E., Mesa, Arizona 85202 (US); Huang, Jenn-Hwa, Gilbert, Arizona 85259 (US); Slocomb, Ronald W., No. 247, Scottsdale, Arizona 85251 (US); Hadizad, Peyman, Scottsdale, Arizona 85259 (US); Salih, Ali, Tempe, Arizona 85284 (US)
(74) Representative: Williamson, Simeon

(57) **Abstract**

A method of fabricating a GaAs vertical FET (20) including implanting a termination species to form termination areas (27) in the surface (24) of a substrate (21) defining transistor boundaries. A gate contact species (28) and a source species (30) are implanted in the surface (24) of the substrate (21) within the boundaries defined by the termination areas (27). Trenches (32) are formed in the surface (24) of the substrate (21) on opposing sides of the source species (30). Carbon and a lattice damaging species are co-implanted to form gate regions (33) in the trenches (32). All of the species and carbon are activated by annealing. Source and gate contacts (12, 11) are formed in communication with the source and gate species (30, 33), and a drain contact (45) is formed on the rear surface (25) of the substrate (21).

## Description

### Field of the Invention

The present invention pertains to vertical field effect transistors and more specifically to gallium arsenide vertical field effect transistors.

### Background of the Invention

GaAs vertical Power FETs have 4 - 8 times lower on-resistance per unit area than standard silicon MOS power devices. GaAs vertical power devices also have excellent reverse switching speed and low stored charge compared to silicon devices. This makes the GaAs vertical FET an excellent device for low voltage power supplies for computers and other portable equipment. It also can be designed to bi-directionally block current which allows one GaAs device to replace two silicon MOS devices in battery chargers and the like.

Prior art (Texas Instruments, Patent #5,231,017, entitled "Method of Making a Power VFET Device Using a P+ Carbon Doped Gate Layer", issued July 27, 1993) describes a method of making a GaAs FET using a carbon doped epi layer for the gate region and regrowing n-GaAs epi over the carbon (p+) region to form the channel region. This method is very costly and the devices are difficult to manufacture with acceptable yields.

It would be highly advantageous, therefore, to remedy the foregoing and other deficiencies inherent in the prior art.

Accordingly, it is an object of the present invention to provide a GaAs vertical field effect transistor.

Another object of the invention is to provide a GaAs vertical field effect transistor having lower on resistance.

And another object of the invention is to provide a GaAs vertical field effect transistor having lower gate capacitance.

Yet another object of the present invention is to provide a GaAs vertical field effect transistor which is more manufacturable with a lower cost.

### Summary of the Invention

Briefly, to achieve the desired objects of the instant invention in accordance with a preferred embodiment thereof, provided is a method of fabricating a GaAs vertical field effect transistor including the steps of providing a GaAs substrate having a first surface and an opposed second surface. A source species is implanted to form a source contact region in the first surface of the substrate. First and second spaced apart gate trenches, each having sidewalls and a bottom, are formed in the first surface of the substrate on opposing sides of the source contact region so as to define a channel region underlying the source contact region. Carbon and a lattice damaging species are co-implanted to form gate regions in the bottoms of the first and second trenches. Source and gate contacts are formed in communication with the source contact region and the gate regions respectively and a drain contact is formed on the second surface of the substrate.

In a specific aspect, the method further includes the step of implanting a termination species to form termination areas in the first surface of the substrate defining the transistor boundaries.

In yet another aspect the method includes the steps of annealing the termination areas, the gate contact regions and the gate regions to activate the termination species, gate contact species, source species, and carbon. The trenches are filled with a first layer of dielectric material and a gate metal lead is formed on the gate contact region. The gate metal lead is covered with a second layer of dielectric material. The dielectric material is etched through to expose a surface of the source contact region.

### Brief Description of the Drawings

The foregoing and further and more specific objects and advantages of the instant invention will become readily apparent to those skilled in the art from the following detailed description of a preferred embodiment thereof taken in conjunction with the drawings, in which:
FIG. 1 is a top plan view of a power vertical FET in accordance with the present invention; and
FIG. 2 is a simplified cross sectional view of a single vertical FET of FIG. 1, taken along line 2-2.

### Description of the Preferred Embodiments

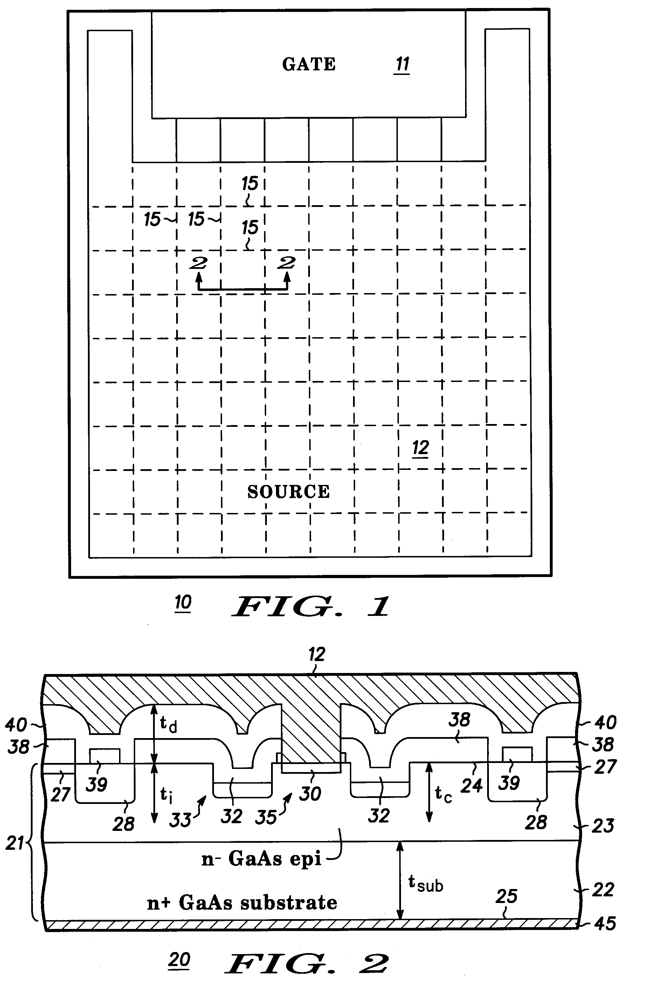

Turning now to the drawings in which like reference characters indicate corresponding elements throughout the several views, attention is first directed to FIG. 1 which illustrates a power vertical field effect transistor (FET) generally designated 10. Power FET 10 includes a gate contact 11 and a source contact 12 on an upper surface thereof. As will be explained presently, a drain contact is located on a lower or reverse surface. Power FET 10 incorporates a plurality of individual vertical FETs connected in parallel by a plurality of gate leads 15 shown by phantom lines. As will be seen presently, source contact 12 connects all of the sources in parallel.

A simplified cross sectional view of an individual vertical FET 20 is illustrated in FIG. 2. FET 20 includes a substrate 21 including a supporting substrate 22 and a drift layer 23 formed on the upper surface of supporting substrate 22. In this preferred embodiment, supporting substrate 22 is an n+ type GaAs and layer 23 is a lightly doped, n-, type epitaxial GaAs layer. The thickness and doping of layer 23 is dependent on specific device requirements. It should be understood that in this embodiment substrate 21 can be a single layer or a plurality of layers, depending on the specific application and materials. Substrate 21, including supporting substrate 22 and epitaxial layer 23, has an upper surface 24 and an opposed lower surface 25. Substrate 21, as will be understood by those skilled in the art, also supports the plurality of similar FETs making up power FET 10.

A lightly doped, p-, region is formed by implanting a termination species such as Be+ in upper surface 24 of substrate 21 to form termination areas 27 defining transistor boundaries. This low doped region provides termination of the electric field using the junction termination technique. It is effective because simply by controlling the charge of an implanted species, the depletion region and electric field can be shaped.

A gate contact region 28 is formed by implanting a gate contact species in upper surface 24 of substrate 21, within the boundaries defined by termination areas 27. Contact regions 28 are deep (1-2µm) p+ regions formed by implanting a species such as Be+. This region makes contact with implanted gate regions as will be discussed below.

A source contact region 30 is formed by implanting a source species in upper surface 24 of substrate 21 in a generally central location. The source contact region 30 is n+ in this preferred embodiment and is formed by implanting Si+ to lower the contact resistance of the source metal. A metal mask (not shown) such as TiW is formed on source contact region 30 and defined by some convenient means such as a reactive ion etch. The metal mask is employed to block gate implants, which will be described presently. First and second spaced apart gate trenches 32, each having sidewalls and a bottom, are etched in upper surface 24 of substrate 21 on opposing sides of source contact region 30 so as to define a channel region 35 underlying source contact region 30. Some convenient means is used to form trenches 32, such as reactive ion etch (RIE) or damage free electron cyclotron resonance (ECR) etching, which are employed to etch clean, straight sidewalls to a depth in a range of approximately 3KÅ - 7KÅ.

Implanting carbon alone into gallium arsenide to form p-type regions is not feasible because the activation of carbon in GaAs is only 5%. However, by using a co-implant with carbon the activation can reach 70%. There are two different types of co-implants that can be used. The first type is an implant that is electrically inactive in GaAs, such as argon or krypton (noble gasses), but causes lattice damage (vacancies). The damage allows the carbon to diffuse more readily. The carbon can then attach itself to arsenic sites where it acts as an acceptor. The second type is an implant from Group III that is electrically active such as aluminum, gallium or indium. In this case the co-implant attaches itself to gallium lattice sites thus opening up more arsenic sites. The arsenic sites are then occupied by carbon which again acts as an acceptor. The second type of implant also induces lattice site damage allowing the co-implant to help increase carbon activation in two ways: lattice site occupation and lattice damage. Carbon and a lattice damaging species are co-implanted to form gate regions 33 in the bottoms of trenches 32.

It is important that channel region 35 be short for vertical FET operation at low operating voltages. If channel region 35 is too wide, a large gate voltage is necessary to pinch off FET 20. This gate voltage gets subtracted from the blocking voltage of FET 20 to determine the drain to source breakdown voltage rating. Channel region 35 has a width less than approximately 1.5 µm and preferably is in a range of approximately 0.8 - 1.2 µm with source contact region 30 being in a range of 0.5 - 0.8µm.

Previous demonstrations of GaAs vertical FETs with implanted gates use beryllium or magnesium as the gate electrode. However, the lateral diffusion of these dopants during annealing makes it impossible to scale the gate pitch below 4µm. Carbon implants have a diffusivity that is three orders of magnitude lower than Be, Zn and Cd, during the thermal anneal needed for implant activation. With carbon implants and co-implants, as used in the present embodiment, the gate pitch is limited only by lithography and can easily be scaled down to the 2.5µm range.

All implants are activated simultaneously using a rapid thermal anneal (800-900°C, 10 - 30 seconds). Specifically, termination areas 27, gate contact regions 28, source contact region 30 and gate regions 33 are annealed to activate the termination species, gate contact species, source species, and carbon.

Next, a layer 38 of a dielectric material such as SiN, SiO2 or spin on glass is deposited in trenches 32 and over surface 24. In this preferred embodiment, a blanket layer of dielectric material is deposited in a range of from 1,000Å - 3,000Å thick. Layer 38 is removed overlying gate contact regions 28. Gate metal leads 39 are formed over and in electrical contact with gate contact regions 28 in order to connect with gate contact 11. A layer 40 of dielectric material is deposited over gate metal leads 39 in order to isolate them from source contact 12. Dielectric layer 40 is etched using RIE to expose a surface of source contact region 30. NiGeAu, NiGeW or other suitable metal are deposited to form source contact 12 in electrical contact with source contact region 30 and NiGeAlPt, AuZn or other suitable metal are deposited to form gate contact 11 in electrical contact with gate metal leads 39. Surface 25 of substrate 21 is thinned and NiGeAu, or other suitable metal is deposited to form a drain contact 45.

The process flow is as follows:

Implant a species such as Be+ into periphery areas of the device to provide junction termination extension (JTE). JTE is effective because simply by controlling an implanted species charge, on can shape the depletion region and electric field.

Implant species such as Be+ at high energies to form a deep p+ region which will contact with the carbon gate regions in designated parts of the cell design. This implant will also allow for a low resistivity ohmic region for the gate metal.

Implant species such as Si+ to form an n+ region for the source ohmic contact.

Deposit metal plus dielectric mask, such as TiW and silicon nitride, and define with reactive ion etch to form a metal mask.

Etch clean, straight sidewall trenches in gallium arsenide epitaxial layer using RIE or ECR etching to a depth of 3KÅ - 7KÅ.

Implant carbon along with another species which damages the GaAs lattice such as A1+ or Ar+. This creates a gate region with carrier concentration greater than 1E19 after activation by anneal. The dose for both species is 1 - 5E15 per cm⁻³ for effective activation. Trenches are electrically connected to deep implanted p+ type regions at each end.

An RIE etch to remove p+ regions from sidewalls of trenches may be performed after implantation. The metal hard mask is removed.

Activate all implants using rapid thermal anneal, with a temperature in a range of 700 - 850°C, for a time of approximately 10 - 30 seconds.

Fill trenches with 1,000Å - 3,000Å of dielectric (i.e. SiO_{X} or Si₃N₄). Spin-on dielectrics are also an alternative.

Form gate metal leads using liftoff or etch using any metal that is ohmic to p+ GaAs.

Deposit dielectric to cover gate metal leads in active regions.

Etch through dielectric to define areas of source metal contact.

Deposit gate contact metal and define.

Deposit source metal contact over all regions except gate metal contact. Define source metal contact.

Backlap (thinning) wafer (n+ GaAs substrate) to compensate for poor thermal characteristics of GaAs.

Deposit NiGeAu or suitable ohmic metal to backside of wafer while on gelpack, which supports substrate for thinning operations.

Remove gelpack and anneal in RTA 350 - 450°C for approximately 60 seconds to form backside ohmic contact (drain) and front side source contact.

Therefore a new and improved GaAs vertical field effect transistor has been disclosed using trenches and carbon/co-implants to form recessed gate regions having lower on resistance and lower gate capacitance than comparable silicon devices. Further, the GaAs vertical field effect transistor is more manufacturable with a lower cost, and can be manufactured with a substantially narrower channel for vertical FET operation at low operating voltages.

Various modifications and changes to the embodiments herein chosen for purposes of illustration will readily occur to those skilled in the art. Various modifications and variations may be made by those skilled in the art without departing from the scope of the invention as defined by the following claims.

Having fully described and disclosed the present invention and preferred embodiments thereof in such clear and concise terms as to enable those skilled in the art to understand and practice same, the invention claimed is:

## Claims

1. A method of fabricating a GaAs vertical field effect transistor characterized by the steps of:
providing a GaAs substrate (21) having a first surface (24) and an opposed second surface (25);
implanting a source species to form a source contact region (30) in the first surface (24) of the substrate (21);
forming first and second spaced apart gate trenches (32), each having sidewalls and a bottom, in the first surface (24) of the substrate (21) on opposing sides of the source contact region (30) so as to define a channel region (35) underlying the source contact region (30);
co-implanting carbon and a lattice damaging species to form gate regions (33) in the bottoms of the first and second trenches (32); and
forming source and gate contacts (12, 11) in communication with the source contact region (30) and the gate regions (33) respectively and a drain contact (45) on the second surface (25) of the substrate (21).

2. A method as claimed in claim 1 further characterized in that the step of co-implanting includes co-implanting carbon and an electrically inactive, in GaAs, lattice damaging species.

3. A method as claimed in claim 1 further characterized in that the step of co-implanting includes co-implanting carbon and a material from group III which is electrically active in GaAs.

4. A method as claimed in claim 1 further characterized in that the step of forming first and second spaced apart gate trenches (32) to define the channel region (35) includes spacing the gate trenches (32) a distance less than approximately 1.5 microns.

5. A method as claimed in claim 1 further characterized by the step of implanting a termination species to form termination areas (27) in the first surface (24) of the substrate (21) defining the transistor boundaries.

6. A method as claimed in claim 5 further characterized by the step of annealing the termination areas (27), the gate contact regions (28), source contact region (30) and the gate regions (33) to activate the termination species, gate contact species, source species, and carbon.

7. A method as claimed in claim 6 further characterized by the steps of:
depositing a first layer of dielectric material in the trenches (32);
forming a gate metal lead (39) on the gate contact region (28) so as to couple the gate regions (33) with the gate contact (11);
covering the gate metal lead (39) with a second layer of dielectric material (40);
etching through the dielectric material (40) to expose a surface of the source contact region (30); and
depositing a source metal contact (12) on the surface of the source contact region (30).

8. A method as claimed in claim 1 further characterized in that the step of forming the trenches (32) includes using one of reactive ion etching and electron cyclotron resonance etching.

9. A method as claimed in claim 8 further characterized in that the step of forming the trenches (32) includes forming the trenches from 3,000 Å - 7,000 Å in depth.

10. A GaAs vertical field effect transistor characterized by:
a GaAs substrate (21) having a first surface (24) and an opposed second surface (25);
a source species implanted to form a source contact region (30) in the first surface (24) of the substrate (21);
first and second spaced apart gate trenches (32), each having sidewalls and a bottom, formed in the first surface (24) of the substrate (21) on opposing sides of the source contact region (30) so as to define a channel region (35) underlying the source contact region (30);
carbon and a lattice damaging species co-implanted to form gate regions (33) in the bottoms of the first and second trenches (32); and
source and gate contacts (12, 11) in communication with the source contact region (30) and the gate regions (33) respectively and a drain contact (45) on the second surface (25) of the substrate (21).
